(19) Europäisches Patentamt
European Patent Office
Office européen des brevets

(11) EP 4 668 325 A1

(12) **EUROPEAN PATENT APPLICATION**

(43) Date of publication:
24.12.2025 Bulletin 2025/52

(21) Application number: 24183491.0

(22) Date of filing: 20.06.2024

(51) International Patent Classification (IPC):
$H01L\ 21/8258^{(2006.01)}$    $H01L\ 27/06^{(2006.01)}$
$H01L\ 27/092^{(2006.01)}$    $H01L\ 29/778^{(2006.01)}$
$H01L\ 29/20^{(2006.01)}$    $H01L\ 21/8238^{(2006.01)}$
$H01L\ 29/775^{(2006.01)}$

(52) Cooperative Patent Classification (CPC):
H10D 88/00; H10D 30/015; H10D 30/475;
H10D 62/123; H10D 64/017; H10D 64/512;
H10D 84/0167; H10D 84/05; H10D 84/85;
H10D 84/851; B82Y 10/00; H10D 30/43;
H10D 30/501; H10D 62/8503; H10D 84/038

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

(54) **CMOS DEVICE WITH HETEROSTRUCTURES AND CORRESPONDING MANUFACTURING METHOD**

(57) An electrical device is provided, the device comprising: an n-channel metal-oxide-semiconductor, NMOS, transistor comprising a source, a body and a drain, wherein the body is an elongated semiconductor heterostructure configured for conduction of negative charge carriers, wherein the source and the drain are arranged on opposite distal regions of the body; and a p-channel metal-oxide-semiconductor, PMOS, transistor comprising a source, a body and a drain, wherein the body is an elongated semiconductor heterostructure configured for conduction of positive charge carriers, wherein the source and the drain are arranged on opposite distal regions of the body; wherein the bodies are arranged separated, in parallel and superimposed relative to each other. The NMOS transistor and the PMOS transistor of the electrical device are connected to form a circuit for a complementary metal-oxide-semiconductor, CMOS. A method of providing an electrical device and a CMOS are also provided.

Fig. 1a

## Description

<u>Technical field</u>

The present disclosure relates to an electrical device, a method of providing an electrical device and a complementary metal-oxide-semiconductor. More specifically, the disclosure relates to an electrical device, a method of providing an electrical device configured to form a circuit for a complementary metal-oxide-semiconductor and a complementary metal-oxide-semiconductor as defined in the introductory parts of the independent claims.

<u>Background art</u>

Complementary CMOS (Complementary Metal-Oxide-Semiconductor) refers to a technology used for constructing integrated circuits, including microprocessors, microcontrollers, static RAM, and other digital logic circuits. The term "complementary" in this context refers to the use of both p-type and n-type MOSFETs (Metal-Oxide-Semiconductor Field-Effect Transistors) in a complementary and symmetrical arrangement. To this end, the MOSFET may be understood as a functional electronic component that acts as a switch or amplifier, using the MOS structure as its gate to control current flow.

CMOS transistors are commonly formed by silicon structures. However, other material structures such as GaN-based technologies have been advancing rapidly, and there are significant research and development focused on integrating such devices with traditional CMOS processes, primarily to leverage the superior properties of GaN for high-power and high-frequency applications. GaN transistors may therefore be used for electrical devices operating at high-power and/or high frequency. Due to the large bandgap of GaN, such transistors may further operate efficiently at higher temperatures than e.g. Si transistors. Integrating GaN structures with CMOS processes may, however, increase complexity and may require advanced fabrication techniques. There is therefore still room for further improvements, for example, in terms of a more efficient charge carrier transport, switching and/or lower power consumption. To this end, efficient p-type GaN-based transistors may moreover be challenging to fabricate compared to the n-type ones, complicating the creation of complementary GaN-based logic circuits.

There is also within the semiconductor industry a need for increased density of logic functions on a chip, i.e. that more transistors can be packed into a smaller area, enabling the creation of complex integrated circuits.

<u>Summary</u>

It is an object of the present disclosure to mitigate, alleviate or eliminate one or more of the above-identified deficiencies and disadvantages in the prior art and solve at least the above-mentioned problems and short comings. It is an objective of the present inventive concept to enable new types of efficient transistors. It is a further objective of the present inventive concept to enable power efficient electrical devices. It is a further objective of the present inventive concept to enable power efficient electrical devices allowing for an and or more controlled transport of charge carriers. It is also an objective to provide electrical devices that may operate at higher power and/or higher frequency. These and other objectives of the inventive concept are at least partly met by the invention as defined in the independent claims. Preferred embodiments are set out in the dependent claims.

In this text abbreviations of the natural elements will be used in accordance with the periodic table. For example, Al means aluminum, Ga means gallium, N means nitride, Si means silicon, and Mg means magnesium.

According to a first aspect there is provided an electrical device comprising: an n-channel metal-oxide-semiconductor, NMOS, transistor, the NMOS transistor comprising a source, a body and a drain, wherein the body is an elongated semiconductor heterostructure configured for conduction of negative charge carriers, wherein the source and the drain are arranged on opposite distal regions of the body; and a p-channel metal-oxide-semiconductor, PMOS, transistor, the PMOS transistor comprising a source, a body and a drain, wherein the body is an elongated semiconductor heterostructure configured for conduction of positive charge carriers, wherein the source and the drain are arranged on opposite distal regions of the body; wherein the bodies are arranged separated, in parallel and superimposed relative to each other, wherein the NMOS transistor and the PMOS transistor of the electrical device are connected to form a circuit for a complementary metal-oxide-semiconductor, CMOS.

An advantage may be that an electrical device is provided having an increased charge carrier transport. Put differently, the mobility of charge carriers in the respective elongated semiconductor heterostructures may be increased. Another advantage may be that the NMOS transistor and the PMOS transistor may extend and be arranged at a smaller distance from each other. The foot print of the electronic device may further be reduced. A larger density of electronic devices may thereby be provided. The controlling of the current flow through the respective charge channels formed within the elongated semiconductor heterostructures may, moreover, be controlled in a more efficient manner.

The n-channel metal-oxide-semiconductor, NMOS, transistor may be understood to as an n-channel MOSFET (NMOS), wherein the channel is formed by electrons. The negative charges conducted may be electrons.

The p-channel metal-oxide-semiconductor, PMOS, transistor may be understood to as a p-channel MOSFET (PMOS), wherein the channel is formed by holes. The positive charges conducted may be holes.

To this end, the term MOSFET may refer to a transistor structure that utilizes a MOS structure to control current flow.

According to some examples, the elongated semiconductor heterostructure of the NMOS transistor comprises a heterojunction configured for the conduction of negative charge carriers, the heterojunction being formed by a top layer and a bottom layer, both extending from a first end to a second end of the body; and wherein the elongated semiconductor heterostructure of the PMOS transistor comprises a heterojunction configured for the conduction of positive charges, the heterojunction being formed by a top layer and a bottom layer, both extending from a first end to a second end of the body.

An advantage may be that an interface between the top layer and the bottom layer may be created with increased accuracy. A uniform interface along the extension of the respective elongated semiconductor heterostructures may be obtained.

The top layer may, according to some examples, be referred to as a first layer. The bottom layer may according to some examples be referred to as a second layer.

The heterojunction should be construed to be formed in the interface between the adjacent top and bottom layers.

It may be understood that the source, body, and drain of the transistor may be part of the same elongated semiconductor heterostructure. However, the elongated semiconductor heterostructure may comprise other parts than the top and bottom layers.

The extension of the elongated semiconductor heterostructure may be understood to be along an axial direction. The axial direction may be perpendicular to an interface surface between the top and bottom layer. According to some examples, the axial direction may be oriented perpendicular to grow direction of the elongated semiconductor heterostructure.

According to some examples, the top and bottom layers are made of AlGaN with an aluminum content of 0% or higher and wherein the content of aluminum in the top layers are different to the content of aluminum in the bottom layers for each of the elongated semiconductor heterostructures.

An advantage may be that an increased transport of charge carriers may be provided at the interface between the top layer and the bottom layer. A further advantage may be that the AlGaN/GaN heterojunctions formed may allow for improved injection of charge carriers and room temperature ballistic transport for complementary metal-oxide-semiconductor devices. The AlGaN/GaN structures may moreover handle higher power densities, making them more suitable for power amplifiers and high-power applications.

The AlGaN-layer and the GaN-layer may be understood to together form a heterojunction within the respective heterostructures.

The elongated semiconductor heterostructure of the NMOS transistor may be formed by a heterostructure comprising one or more AlGaN/GaN layer structures. The heterostructure may comprise an undoped GaN layer and an AlGaN layer, the AlGaN layer may being arranged on top of the GaN layer. The GaN layer may be formed by Ga polar GaN.

The one or more AlGaN/GaN layer structures may allow for higher switching frequency, higher breakdown voltage and higher power generation. A 1-dimensional electron gas, 1DEG, may be formed at or adjacent to the interface of the one or more AlGaN/GaN layer structures. An advantage may be that an improved charge carrier transport is achieved.

The elongated semiconductor heterostructure of the PMOS transistor may be formed by a heterostructure comprising one or more GaN/AlGaN layers. The heterostructure may comprise an AlGaN layer and an undoped GaN layer, the undoped layer being arranged on the AlGaN layer. The GaN layer may be formed be Ga polar GaN.

According to some embodiments a hole gas is formed at the interface between the GaN/AlGaN in the elongated semiconductor heterostructures.

An advantage may be that an improved charge carrier transport is achieved.

According to some examples, the Al content in AlGaN layer may be between 20-40 %, preferably 23-30 % for the heterostructure on the NMOS transistor.

According to some examples, the Al content in AlGaN layer between 20-40 %, preferably 23-30 % for PMOS transistor.

According to some examples, each of the elongated semiconductor heterostructures has an axial length in a range of 200 to 50 nm and a largest cross section being less than 10 nm, preferably less than 5 nm.

An advantage may be that the density of electronic devices may be increased. The number of channels for charge transfer on a single device may further be increased. An advantage of having elongated semiconductor heterostructures with these dimensions may be that an electron gas and a hole gas may respectively be formed in the NMOS and PMOS transistor allowing for improved charge carrier transport. The dimensions may, moreover, provide efficient injection and transport of charge carriers in 1-dimensional electron gas (1DEG) and 1-dimensional electron hole gas (1DHG) formed within the respective elongated semiconductor heterostructures.

The transport of charge carriers may comprise ballistic transport. Put differently, or 1-dimensional charge transport for complementary field effect transistors (FETs) may be provided.

In more detail, GaN as a material has a lighter effective mass for charge carriers and its high band gap blocking voltage is also beneficial for ballistic transport at room temperature.

This is in contrast to conventional devices being based on 2-dimensional electron gas (2DEG) and 2-dimensional electron hole gas (2DHG) has a 2-dimensional density of states that is constant $n_{2D}(E) = \frac{m}{\pi\hbar^2}$ . The density of states, DOS, is $n_{1D}(E) = \frac{2}{\pi\hbar}\sqrt{\frac{2m}{E}}$ that diverges as $E \to 0$.

Due to the higher effective mass of holes in the present electrical device a complementary CMOS may be provided with 1-dimensional semiconductors forming a 1DHG. In some examples, the amount of strain polarization may be set to provide light holes with lower effective mass for 1-dimensional semiconductors.

The electrical device may comprise the NMOS transistor and/or the PMOS transistor may comprise additional heterojunctions for electron and hole transport respectively.

An advantage may be that the mobility for charge carrier transport may be increased by the plurality of heterojunctions. Put differently, each of the elongated semiconductor heterostructures may comprise a stack of layers forming heterojunctions.

According to some examples, the number of heterojunctions may differ between the NMOS transistor and the PMOS transistor. By way of example, the number of heterojunctions in the PMOS transistor may be larger than the number of heterojunctions in the NMOS transistor. A relatively lower mobility for hole transport than for electron transport may thereby be compensated for. A more symmetric complementary CMOS may thereby be provided. The performance of the electronic device and thereby the performance of the CMOS may be increased.

According to some examples, each of the elongated semiconductor heterostructures has a thickness in the range of 1-10 nm, preferably in the range 3-5 nm.

An advantage may be that the elongated semiconductor heterostructures may efficiently create electron or hole gases in the interfaces between the layers of the heterostructure, e.g. the top and bottom layers. Put differently, thin quantum confined layers, for example of AlGaN/GaN, may efficiently create a 1DEG at the interface due to the differences in polarization and band alignment i.e. substantially restricting electrons in two dimensions and being free in a third dimension. This 1DEG may provide a higher density of electrons or holes that may be transported along the elongated semiconductor heterostructure with increased mobility. An electronic device having higher charge carrier mobility, i.e. electrons or holes, may enable improved high-speed and high-frequency applications.

In other words, an advantage may be that a 1-dimensional channel for charge carriers is provided. A one-dimensional density of states, DOS, may thereby be provided. An increased mobility for the charge carriers along the length of the channel may thereby be provided.

Put differently an improved transport of charge carriers along the respective elongated semiconductor heterostructures may be achieved.

A further advantage being that the thickness of the elongated semiconductor heterostructures may be controlled, e.g. by metalorganic vapor phase epitaxy (MOVPE), with increased precision, down to the atomic level and with abrupt interfaces. An improved control for forming the heterojunctions may be achieved. An increased charge carrier mobility may thereby be achieved.

According to some examples, an insulating material is arranged in between the bodies of the NMOS transistor and the PMOS transistor.

An improved electrostatic control over the charge transport within the respective transistors may be provided. The insulating material may further allow for a gate to better modulate the channel conductivity effectively.

According to some examples, the insulating material is part of a cladding, the cladding enclosing the bodies.

The insulating material may efficiently passivate surfaces of the bodies. A reduction in surface states and traps that could increase the scattering of charge carriers transported within the bodies may be obtained. An increased mobility may be achieved. The insulating material may reduce leakage currents between the bodies of the elongated semiconductor heterostructures and the surroundings, e.g. the substrate, other components or between the two elongated semiconductor heterostructures. A lower power consumption and higher device reliability may be achieved. The cladding may further offer improved thermal management. The cladding may provide mechanical support to the elongated semiconductor heterostructures.

The cladding may be arranged to extend along the axial direction of the bodies.

The enclosing may be understood as circumferentially enclosing.

By way of example, the insulating material may comprise or be formed by hafnium oxide, HfO. The insulating material may comprise or be formed by hafnium oxynitride, HfO(x)N(y).

The insulating material may comprise or be formed by Gadolinium oxide, Gd2O3.

The NMOS transistor may be arranged in relation to the PMOS transistor such that the drain of the NMOS transistor is arranged superimposed with the source of the PMOS transistor.

An advantage may be that a more compact electrical device may be provided. The contacting of the source and drain may further be simplified. A higher density of electronic devise may moreover be provided within a given area.

The drain of the NMOS transistor may alternatively be arranged superimposed with the drain of the PMOS transistor.

According to some examples, the electrical comprises a gate for controlling the charge carriers in the NMOS transistor and the PMOS transistor, wherein the gate comprises a gate cladding structure enclosing a central portion of the bodies.

A more efficient control of the transport of charge carriers within the elongated semiconductor heterostructures may be achieved. Put differently, the modulation of the conductance of the channel between the source and drain may be improved. An improved electrostatic control over the charge transfer may further reduce short-channel effects.

The wording "a gate cladding structure enclosing" may be understood to be circumferentially enclosing. The gate cladding structure may enclose a substantial portion of the bodies of the NMOS transistor and the PMOS transistor.

The gate may be understood as a gate contact forming a contact, wherein the insulating material is arranged between the gate contact and the body. An applied bias on the gate contact may create an electric field in the body, under the electrical insulator. The applied bias may thereby control the conduction of negative charge carriers between the source and the drain, via the body.

According to some examples, the gate comprises a gate layer stack structure that comprises a first layer, the first layer comprises Ti and/or Ta, a second layer arranged on the first layer, the second layer the electrical comprises Al, a third layer arranged on the second layer, the third layer the electrical comprises one or more of Ni, Ti, Pt, Pd, Mo, Re, Ir, and a fourth layer arranged on the third layer, the fourth layer the electrical comprises Au.

An advantage being that the gate layer stack structure may allow for improved work function tuning, thermal stability, and/or compatibility with the insulating material. An improved tailoring of the work functions and/or threshold voltages for controlling the carrier transport in the NMOS and PMOS transistors may be achieved. The material may further offer an improved adhesion and compatibility with the adjacent materials. An improved tuning of the resistive properties of the gate may further be provided. The quality of the ohmic contact formed may be increased.

According to some examples, the electrical device may be arranged on a substrate and wherein the elongated semiconductor heterostructures of the NMOS transistor and the PMOS transistor are arranged such that the elongation extends is a direction being parallel to the surface of the substrate.

An advantage may be that a small foot print is provided. The robustness of the electrical device may, moreover, be improved.

According to some examples, the electrical device may be grown on and above the substrate. The substrate may be a silicon substrate. The silicon substrate may be a <111> substrate. The silicon substrate may comprise a GaN layer. The GaN layer may be arranged on the substrate. The substrate may comprise a strain relief layer on which the GaN is grown. The strain relief layer may be formed by AlGaN layers on and above an AlN nucleation layer. The strain relief layer and the AlN nucleation layer may form a buffer layer for a GaN layer. The AlGaN layer may be formed by a stack of AlGaN layers. The stack of AlGaN layers may form a graded buffer layer.

According to other examples the substrate may be e.g. a SiC, or sapphire substrate.

According to a second aspect there is provided a method of providing an electrical device configured to form a circuit for a complementary metal-oxide-semiconductor, CMOS, the method comprising: forming a first stack of layers on a substrate, the first stack of layers comprising a first semiconductor heterostructure comprising a top layer and a bottom layer, and sacrificial layers arranged above and below the first stack of layers; forming a second stack of layers on and above the first stack of layers, the second stack of layers comprising a second semiconductor heterostructure comprising a top layer and a bottom layer, and sacrificial layers arranged above and below the second stack of layers; etching the first and the second stack of layers substantially in the vertical direction relative to the substrate such that the semiconductor heterostructures form elongated semiconductor heterostructures; etching the sacrificial layers; forming an insulating material in the form of a cladding, the cladding enclosing the elongated semiconductor heterostructures.

An improved process for forming the electrical device may be obtained. An advantage may be that the formation of the elongated semiconductor heterostructures may be made efficiently. The thickness of the elongated semiconductor heterostructure may be controlled with improved efficiency.

The wording "substantially in a vertical direction" may be understood as in a direction being perpendicular to the substrate surface. The vertical direction may be parallel to the surface normal of the substrate.

The forming of the insulating material in the form of cladding should be understood as the cladding being arranged to enclose a substantial part of the elongated heterostructures is arranged to extend along the axial direction of the bodies.

According to some examples, further the method comprises: forming a gate substantially enclosing the insulating material and the first and the second stack of layers.

The enclosing may comprise enclosing a cladding of insulating material. The forming of the gate may further comprise forming a gate cladding structure enclosing a central portion of the bodies of the elongated semiconductor heterostructures.

According to some examples, the forming of the first stack of layers comprises forming the first and second semiconductor heterostructures such that the respective top layers and bottom layers, are made of AlGaN with an aluminum content of 0% or higher and wherein the content of aluminum in the top layers s are different to the bottom layers.

According to some examples, the first semiconductor heterostructure comprises a first undoped GaN layer and a first AlGaN layer arranged on the first undoped GaN layer and the second semiconductor heterostructure comprises second AlGaN layer and a second undoped GaN layer arranged on the second AlGaN layer.

The skilled person realizes the order of the arrangement of the first semiconductor heterostructure and the second semiconductor heterostructure may be reversed. To this end, the relative order of the n-channel metal-oxide-semiconductor, NMOS, transistor and the p-channel metal-oxide-semiconductor, PMOS, transistor, may be reversed within the electrical device.

The method may further comprise forming a gate layer stack structure.

The method may further comprise forming a source and the drain arranged on opposite distal regions of the body of the elongated semiconductor heterostructures.

The method may further comprise forming elongated one or more vias in or on the substrate, the elongated vias extending in length parallel to the elongated semiconductor heterostructures and comprises GaN.

An advantage being that conductive pathways for electrical connections are provided. The electrical connections may serve as power rails. A more efficient contacting of the source and/or drain may thereby be achieved.

According to a third aspect there is provided a complementary metal-oxide-semiconductor, CMOS, comprising the electrical device according to the first aspect.

The complementary CMOS may further comprise a capacitive load arrange between an output connector from the complementary CMOS and ground. An advantage being that a more stable output may be achieved. An improved signal filtering may moreover be achieved.

Effects and features of the second and third aspects are to a large extent analogous to those described above in connection with the first aspect. Examples mentioned in relation to the first aspect are largely compatible with the second and third aspects.

The present disclosure will become apparent from the detailed description given below. The detailed description and specific examples disclose preferred examples of the disclosure by way of illustration only. Those skilled in the art understand from guidance in the detailed description that changes and modifications may be made within the scope of the disclosure.

Hence, it is to be understood that the herein disclosed disclosure is not limited to the particular component parts of the device described or steps of the methods described since such device and method may vary. It is also to be understood that the terminology used herein is for purpose of describing particular examples only, and is not intended to be limiting. It should be noted that, as used in the specification and the appended claim, the articles "a", "an", "the", and "said" are intended to mean that there are one or more of the elements unless the context explicitly dictates otherwise. Thus, for example, reference to "a unit" or "the unit" may include several devices, and the like. Furthermore, the words "comprising", "including", "containing" and similar wordings does not exclude other elements or steps.

Brief descriptions of the drawings

The above objects, as well as additional objects, features and advantages of the present disclosure, will be more fully appreciated by reference to the following illustrative and non-limiting detailed description of example examples of the present disclosure, when taken in conjunction with the accompanying drawings.

Figures 1a to 1c show schematically different views of an electrical device according to some examples.

Figure 1d shows schematically a circuit diagram for a complementary metal-oxide-semiconductor, CMOS according to some examples.

Figure 2 shows a flowchart schematically illustrating a method of providing an electrical device configured to form a circuit for a complementary metal-oxide-semiconductor, CMOS according to some examples.

Figures 3 to 6 show schematically different intermediate steps in the providing an electrical device configured to form a circuit for a complementary metal-oxide-semiconductor, CMOS according to some examples.

Figure 7 shows schematically a side view of an electrical device according to some examples.

Figure 8 shows schematically a side view of an electrical device according to some examples.

Detailed description

The present disclosure will now be described with reference to the accompanying drawings, in which preferred example examples of the disclosure are shown. The disclosure may, however, be embodied in other forms and should not be construed as limited to the herein disclosed examples. The disclosed examples are provided to fully convey the scope of the disclosure to the skilled person.

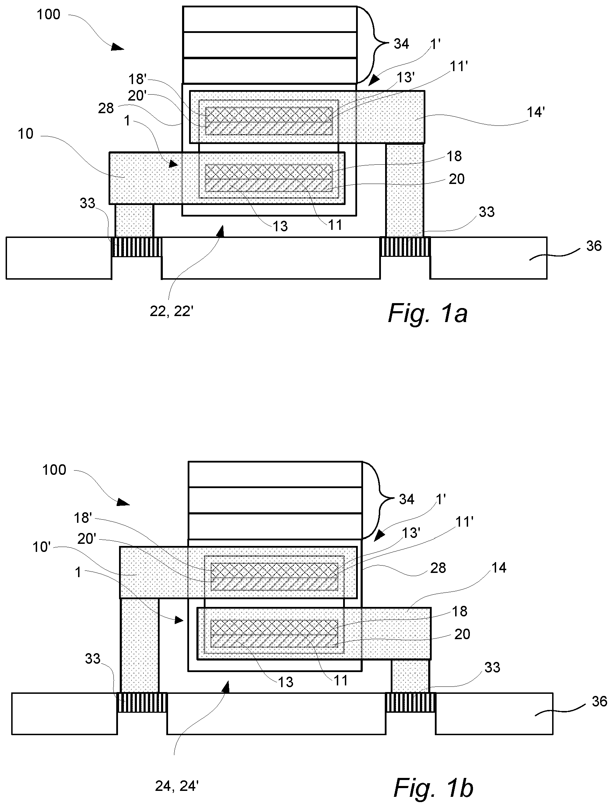

Figures 1a to 1c show schematically different views of an electrical device 100. The electrical device 100 comprises: an n-channel metal-oxide-semiconductor, NMOS, transistor 1. The NMOS transistor 1 comprises a source 10, a body 12 and a drain 14. The body 12 is an elongated semiconductor heterostructure 13 configured for conduction of negative charge carriers, i.e. for electron transport. The source 10 and the drain 14 are arranged on opposite distal regions 15,17 of the body 12.

The electrical device 100 further comprises a p-channel metal-oxide-semiconductor, PMOS, transistor. The PMOS transistor 1' comprises a source 10', a body 12' and a drain 14'. The body 12' is an elongated semiconductor heterostructure 13' configured for conduction of positive charge carriers, i.e. for hole transport. The source 10' and the drain 14' are arranged on opposite distal regions 15',17' of the body 12'.

The bodies 12,12' of the NMOS and the PMOS transistors 1, 1' are arranged separated, in parallel and superimposed relative to each other. As illustrated in Figures 1a-1c the PMOS transistor 1' is arranged above the NMOS transistor 1. The order may be reversed. The NMOS transistor 1 and the PMOS transistor 1' of the electrical device 100 are connected to form a circuit 200 for a complementary metal-oxide-semiconductor, CMOS 300.

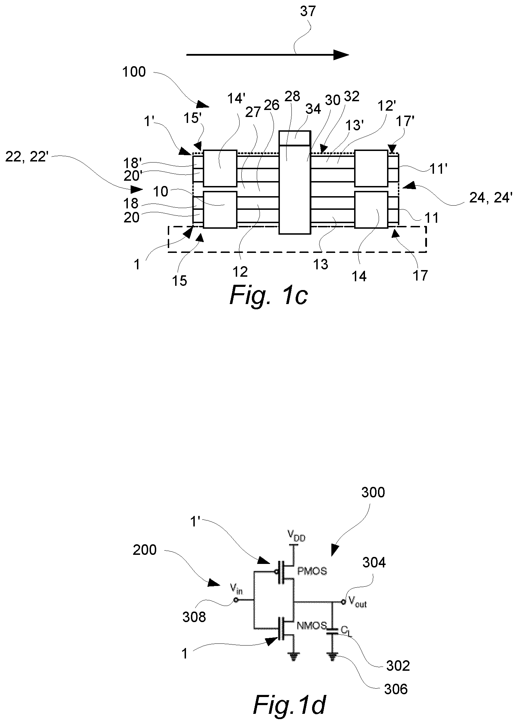

The electrical device 100 may be arranged on a substrate 36. The elongated semiconductor heterostructures 13, 13' of the NMOS transistor 1 and the PMOS transistor 1', may be arranged such that the elongation extends is a direction 37 a being parallel to the surface of the substrate 36, see Figure 1c.

The NMOS transistor 1 may be arranged in relation to the PMOS transistor 1' such that the drain 14 of the NMOS transistor 1 is arranged superimposed with the source 12' of the PMOS transistor 1', see Figures 1a-1c.

A circuit diagram for a CMOS 300 is schematically illustrated in Figure 1d. In the circuit diagram the NMOS and PMOS transistors 1,1' are illustrated for clarity. The complementary CMOS may further comprise a capacitive load 302. The capacitive load 302 may be arranged between an output connector 304 from the complementary CMOS and ground 306. Illustrated in Figure 1d is further an input connector 308. It is further visible in Figure 1d that the gate for both transistors 1,1' is connected to the input connector 308.

With further reference to Figures 1a-1c, the elongated semiconductor heterostructure 13 of the NMOS transistor 1 may comprise a heterojunction 11. The heterojunction 11 is configured to for conduction of negative charge carriers. Put differently, the heterojunction 11 may be arranged to enable electron transport when the electronic device 100 is in operation.

The heterojunction is formed by a top layer 18 and a bottom layer 20. The top layer 18 and the bottom layer 20 are both extending from a first end 22 to a second end 24 of the body 12. The side view in Figure 1 illustrates the first end 22,22'. The opposite side view in Figure 1b illustrates the second end 24,24'. The elongated semiconductor heterostructure 13' of the PMOS transistor 1' comprises heterojunction 11' configured for the conduction of positive charges. Put differently, the heterojunction 11' may be arranged to enable hole transport when the electronic device 100 is in operation.

The heterostructure 11' is formed by a top layer 18' and a bottom layer 20', both extending from a first end 22' to a second end 24' of the body 12', see Figures 1a and 1b.

Figure 1c shows schematically a side view along the extension of the of the elongated semiconductor heterostructures 13, 13'. The extension of the elongated semiconductor heterostructure may be refereed to along an axial direction 37. The axial direction 37 may be a direction perpendicular to an interface surface between the top layer 18,18' and bottom layer 20.20'. According to some examples, the axial direction 37 may be oriented perpendicular to grow direction of the elongated semiconductor heterostructures 13,13'. The interface surface may be parallel to the surface of the substrate 36.

An insulating material 26 may be arranged in between the bodies 12,12' of the NMOS transistor 1 and the PMOS transistor 1', see Figure 1c. The insulating material 26 may form part of a cladding 27. The cladding 27 enclosing the bodies 12,12'. The cladding 27 may enclose the bodies 12, 12' fully or at a substantial part of them. The cladding 27 may at least enclose portion of the bodies 12, 12'.

The electrical device 100 may comprise a gate 28. The gate 28 is arranged to control the charge carriers in the NMOS transistor 1 and the PMOS transistor 1'. The gate 28 may comprise a gate cladding structure 30 enclosing a central portion 32 of the bodies 12,12'.

The gate 28 may further comprise a gate layer stack structure 34. The gate layer stack structure 34 may comprises a first layer the electrical comprises Ti and/or Ta, a second layer arranged on the first layer, the second layer the electrical comprises Al, a third layer arranged on the second layer, the third layer the electrical comprises one or more of Ni, Ti, Pt, Pd, Mo, Re, Ir, and a fourth layer arranged on the third layer, the fourth layer the electrical comprises Au. The gate layer stack structure 34 and the four layers are illustrated in Figure 1a and 1b.

According to some examples, the top and bottom layers 18, 18', 20, 20' may be made of AlGaN with an aluminum content of 0% or higher and wherein the content of aluminum in the top layers 18,18' are different to the content of aluminum in the bottom layers 20,20' for each of the elongated semiconductor heterostructures 13,13'.

The heterojunction 11 configured to conduct negative charges, e.g. for enabling electron transport, may be formed by a top layer 18 of AlGaN formed on a bottom layer 20 of GaN.

The heterojunction 11' configured to conduct positive charges, e.g. for enabling hole transport, may be formed by a top layer 18' GaN formed on a bottom layer 20' of AlGaN.

Each of the elongated semiconductor heterostructures 13,13' may have an axial length in a range of 200 to 50 nm and a largest cross section being less than 10 nm, preferably less than 5 nm.

Each of the elongated semiconductor heterostructures 13,13' may have a thickness in the range of 1-10 nm, preferably in the range 3-5 nm.

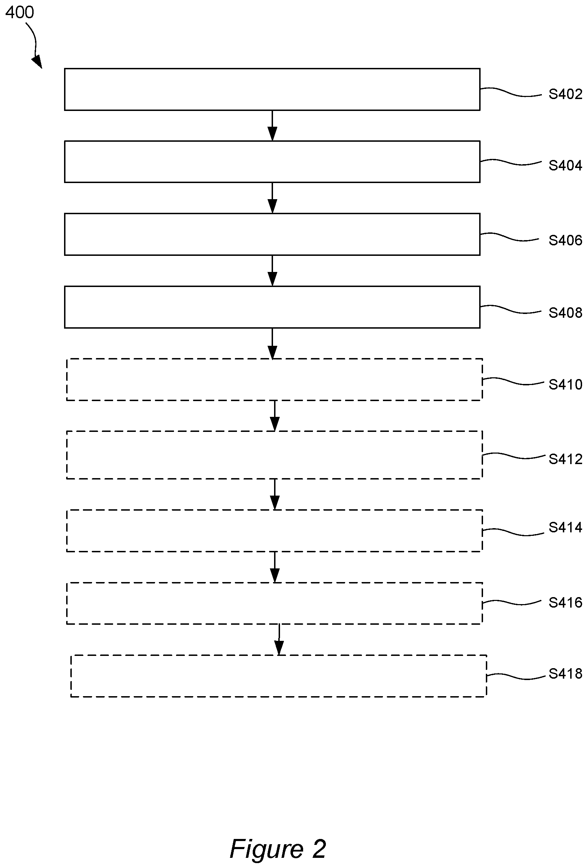

With reference to Figures 2 and Figures 3 - 6, a method of providing an electrical device 100 configured to form a circuit 200 for a complementary metal-oxide-semiconductor, CMOS, 300, is be described.

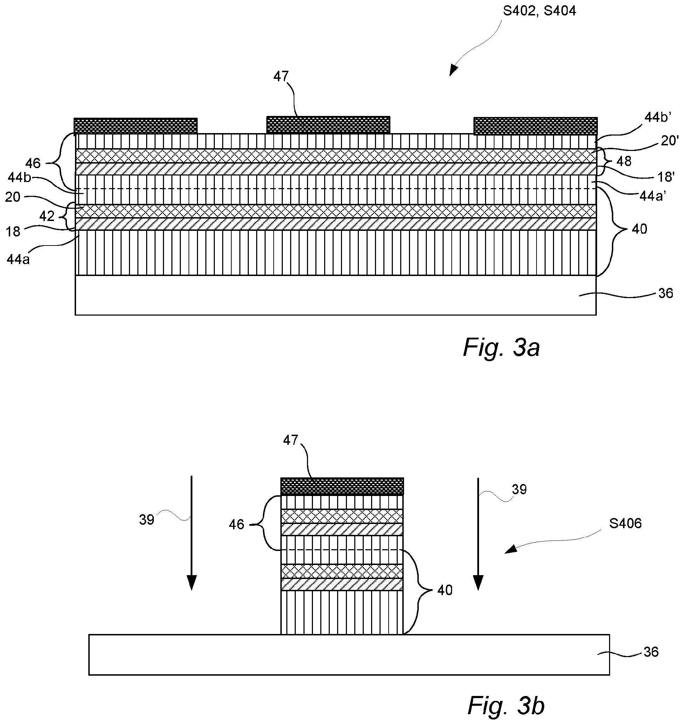

The method 400 comprises forming S402 a first stack of layers 40 on a substrate 36, the first stack of layers 40 comprising a first semiconductor heterostructure 42, and sacrificial layers 44a,44b. The first semiconductor heterostructure 42 comprises a top layer 18, and a bottom layer 20. The sacrificial layers 44a,44b are arranged above and below the first stack of layers 40, see Figures 2 and 3a.

The method 400 also comprises forming S404 a second stack of layers 46 on and above the first stack of layers 40. The second stack of layers 46 comprises a second semiconductor heterostructure 48. The second semiconductor heterostructure 48 comprises a top layer 18' and a bottom layer 20'. The sacrificial layers 44a',44b' are arranged above and below the second stack of layers 46, see Figures 2 and 3a. The sacrificial layers 44b and 44a' arranged between the top layer 20 of the first semiconductor heterostructure 42 and the bottom layer 18' of the second semiconductor heterostructure 48 may be a combined common layer.

The first and second semiconductor heterostructures 42, 48 and/or sacrificial layers 44a, 44a', 44b, 44b' may be epitaxially grown sequentially in the GaN growth direction e.g. C-direction of the crystal structure wurtzite, by metal organic vapor phase epitaxy, MOVPE. However, other epitaxial growth methods may alternatively be used, e.g. molecular beam epitaxy, MBE. The first and the second semiconductor heterostructures 42, 48 may be epitaxially grown in one growth session or in several sessions.

The sacrificial layers 44a, 44a', 44b, 44b' may be grown in the same or in additional growth sessions as the first and second semiconductor heterostructures 42, 48.

By way of example, dopants of n-type may be introduced in the gas phase of the MOVPE. Precursors such as e.g. trimethyl gallium (TMG), trimethyl aluminum (TMA), and NH3 may be used for the growth.

According to some examples, dopants of p-type, e.g. Mg, may be introduced in the gas phase of the MOVPE. The aluminum content may be changed by changing precursor flows during the epitaxial growth, e.g. by changing a TMG/TMA ratio.

According to some examples the source/body/-drain of the NMOS transistor may be doped. The source may be n-doped (e.g. strongly n-doped, commonly denoted by n+), the body may be p-doped, and the drain may be n-doped. Put differently, the doping for the source/body/drain may be n/p/n or n+/p/n+.

The source/body/drain of the PMOS may be doped. The source may be p-doped (e.g. strongly p-doped, commonly denoted by p+), the body may be n-doped, and the drain may be p-doped. Put differently the doping of the source/body/drain may be p/n/p, e.g. p+/n/p+.

The p-doping may refer to doping by Mg from e.g. the precursor Bis(cyclopentadienyl)magnesium, Cp2Mg. However, the same enhancement mechanism may also apply to other p-dopant e.g. Boron

The n-doping may refer to doping by Si from e.g. the precursor SiH4. However, GaN-based materials may, at least under some circumstances, be intrinsically n-type. Thus, a n-doped region may not necessarily be actively doped.

The forming S402 of the first stack of layers 40 may comprise forming the first and second semiconductor heterostructures 13, 13' such that the respective top layers 18, 18' and bottom layers 20, 20', are made of AlGaN with an aluminum content of 0% or higher and wherein the content of aluminum in the top layers 18, 18's are different to the bottom layers 20, 20'.

The first semiconductor heterostructure 13 may comprise a first undoped GaN layer and a first AlGaN layer arranged on the first undoped GaN layer and the second semiconductor heterostructure 13' comprises second AlGaN layer and a second undoped GaN layer arranged on the second AlGaN layer.

The method comprises etching steps performed on the formed structures. The etching S406 comprises etching the first and the second stack of layers 40, 46 substantially in the vertical direction 39 relative to the substrate 36, compare Figures 3a and 3b.

As a result, the semiconductor heterostructures 42, 48 form elongated semiconductor heterostructures 13, 13'. The vertical etch direction 39 may be understood as being perpendicular to the surfaces of the respective heterostructure layers. The vertical direction 39 may be perpendicular to the surface of the substrate.

The etching S406 may be done by wet etching, e.g. using hydrofluoric acid, or by dry etching, e.g. by reactive ion etching. In more detail, the etching S406 of the first and second stack of layers 40, 46 may be performed by a physical etch. This etching may be referred to as a physical etch. The etching S406 may be by plasma etching. An advantage may be that the plasma etch etches substantially in a downward direction (towards the substrate 36) with reduced or no inclined sidewalls.

The physical etching may be achieved by use of one or more etch masks 47. The one or more etch masks 47 may be referred to as hard masks. The masking may be achieved by lithographical patterning, e.g. by nanoimprint lithography, NIL. The etching may be to exposed areas, i.e. areas not covered by the mask.

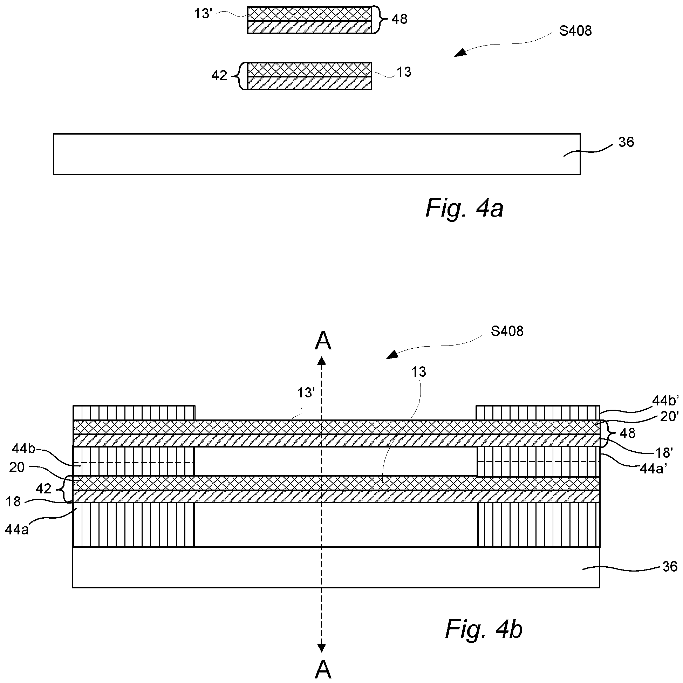

The method 400 further comprises etching S408 the sacrificial layers 44a, 44b, 44a', 44b', compare Figures 3b and 4a. Figure 4b further illustrates schematically the same structure as in Figure 4a, but from a different side view such that the extension of the elongated semiconductor heterostructures 13, 13' formed are illustrated. In Fig 4a the elongated semiconductor heterostructures 13, 13' have their main extension into the "paper". That is Fig 4a illustrated a cross section relative to Fig 4b as taken in the plane A-A indicated in Fig 4b.

The etching S408 of the sacrificial layers may be performed by a chemical etch. This etching S408 may be referred to as a chemical etch. The chemical etch may be a directional etch. The etching may be performed by reactive ion etching.

The sacrificial layers may be formed by one or more InGaN or doped GaN alloys. The one or more InGaN alloys may be configured to form Inl3 and InBr3 etch products when etched. Alternatively, etch selectivity of GaN to AlGaN may be configured.

An etch selectivity of GaN and InGaN relative to AlGaN may be used for the etching S408.

The sacrificial layer of the first stack of layers and one sacrificial layer of the second stack of layers may be the same layer according to some embodiments.

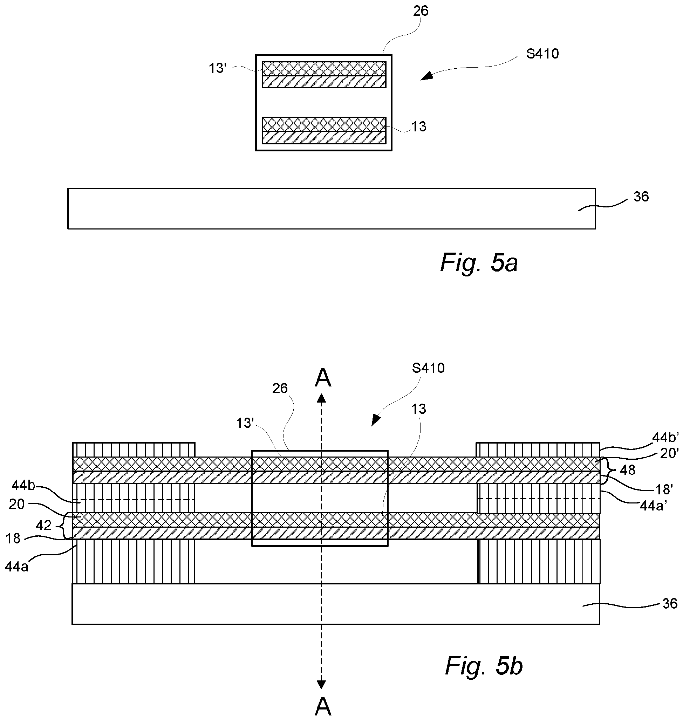

With further reference to Figure 2 and Figures 5a and 5b, the method 400 may comprise forming S410 an insulating material 26 in the form of a cladding. The cladding enclosing the elongated semiconductor heterostructures 13, 13'. In Fig 5a the elongated semiconductor heterostructures 13, 13' have their main extension into the "paper". That is Fig 5a illustrated a cross section relative to Fig 5b as taken in the plane A-A indicated in Fig 5b.

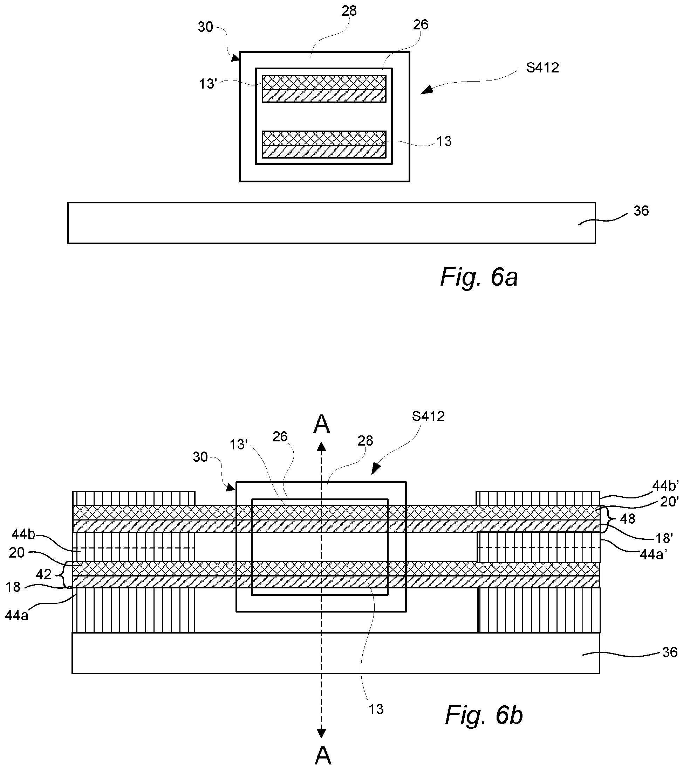

With further reference to Figure 2 and Figures 6a and 6b the method 400 may comprise forming S412 a gate 28 substantially enclosing the insulating material 26 and the first and the second stack of layers 40, 46. In Fig 6a the elongated semiconductor heterostructures 13, 13' have their main extension into the "paper". That is Fig 6a illustrated a cross section relative to Fig 6b as taken in the plane A-A indicated in Fig 6b.

The enclosing may comprise enclosing a cladding of insulating material 26. The forming S412 of the gate 28 may further comprise forming a gate cladding structure 30 enclosing a central portion 32 of the bodies 12, 12' of the elongated semiconductor heterostructures 13, 13'.

An insulating material, e.g. an oxide, may be arranged to electrically insulate the respective elongated semiconductor heterostructures semiconductor structure from each other and from the gate. The electrical insulator may be e.g. Al2O3, Hf02, or Y2O3.

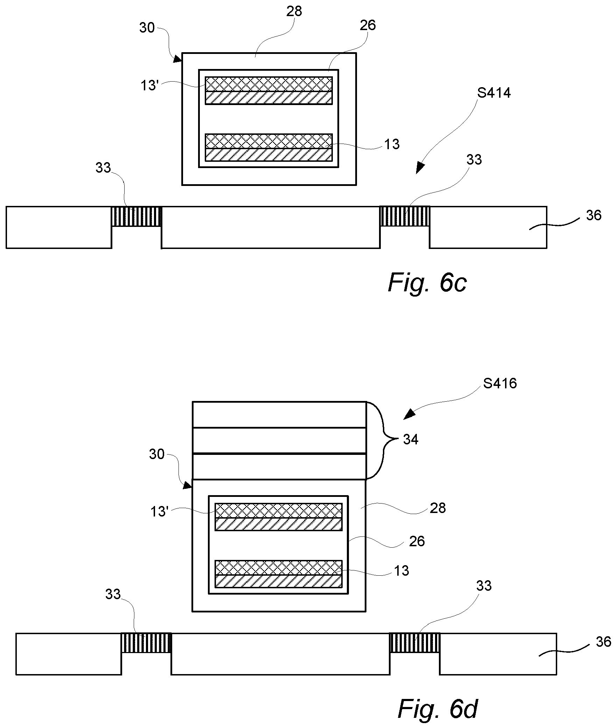

With reference to Figure 2 and Figure 6c, the method 400 may further comprise forming S414 one or more vias 33 in or on the substrate 36. The vias 33 may extend in length parallel to the elongated semiconductor heterostructures 13,13'. The vias 33 may be understood to form elongated structures. The vias 33 may comprise or be formed by GaN. An advantage being that conductive pathways for electrical connections are provided. The electrical connections may serve as power rails. A more efficient contacting of the source and/or drain may thereby be achieved.

With reference to Figure 2 and Figure 6d, the method 400 may comprise forming S416 a gate layer stack structure 34.

With reference to Figure 2, 7, and 1a-1c, the method 400 may comprise forming S418 a source 10,10' and the drain 14,14' arranged on opposite distal regions 15,17 of the body 12,12' of the elongated semiconductor heterostructures 13,13'.

The method 400 of Figure 2 is here described to comprise a number of steps S402-S418. It should, however be understood that some of the steps are optional, as indicated in the Figure 2. It should also be understood that at least some of the steps may be performed in a different order than indicated in Figure 2, as readily understood by the skilled person.

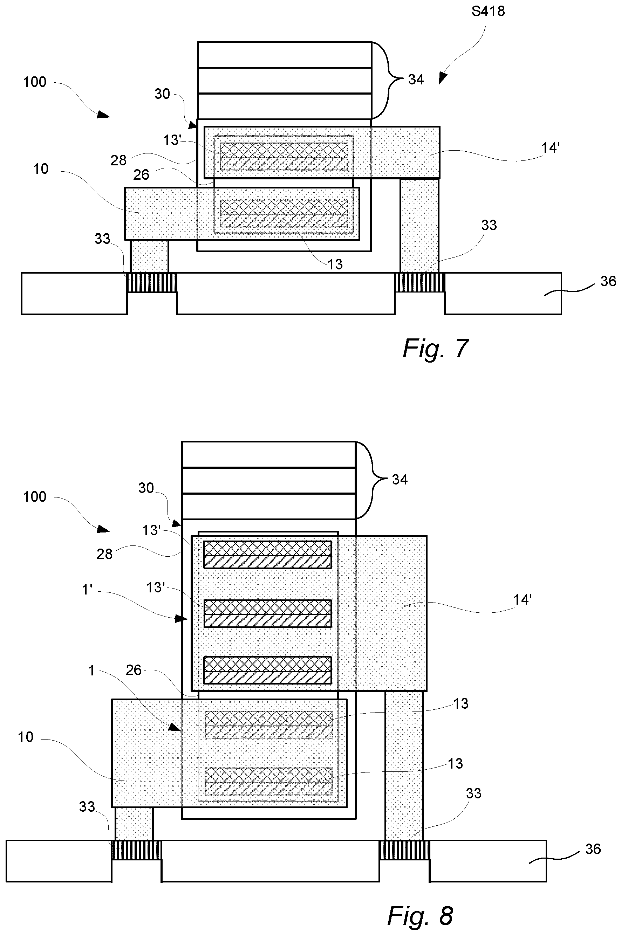

Figure 8 illustrates schematically that that an electrical device 100. The electrical device 100 may be arranged such that the NMOS transistor 1 and/or the PMOS transistor 1' may comprise additional heterojunctions for electron and hole transport respectively. Put differently, the NMOS transistor and/or the PMOS transistor may comprise a plurality of elongated semiconductor heterostructures 13, 13'.

Each of the elongated semiconductor heterostructures 13, 13', may comprise a one or more pairs of top and bottom layers in the first and second stack of layers.

To this end, the number of heterojunctions may differ between the NMOS transistor 1 and the PMOS transistor 1'. By way of example, the number of heterojunctions 11' in the PMOS transistor 1' may be larger than the number of heterojunctions 11 in the NMOS transistor 1. This is illustrated by way of example by the 3 heterojunctions 11' in the PMOS transistor 1' and the 2 heterojunctions 11 in the NMOS transistor 1 in Figure 8.

The relatively lower mobility for hole transport than for electron transport may thereby be compensated for. A more symmetric complementary CMOS may thereby be provided. The performance of the electronic device and thereby the performance of the CMOS may be increased. An advantage may be that the mobility for charge carrier transport may be increased by the plurality of heterojunctions.

The person skilled in the art realizes that the present disclosure is not limited to the preferred examples described above. The person skilled in the art further realizes that modifications and variations are possible within the scope of the appended claims. Additionally, variations to the disclosed examples can be understood and effected by the skilled person in practicing the claimed disclosure, from a study of the drawings, the disclosure, and the appended claims.

Claims

1. An electrical device comprising:

an n-channel metal-oxide-semiconductor, NMOS, transistor (1), the NMOS transistor (1) comprising a source (10), a body (12) and a drain (14), wherein the body (12) is an elongated semiconductor heterostructure (13) configured for conduction of negative charge carriers, wherein the source (10) and the drain (14) are arranged on opposite distal regions (15,17) of the body (12); and
a p-channel metal-oxide-semiconductor, PMOS, transistor, the PMOS transistor (1') comprising a source (10'), a body (12') and a drain (14'), wherein the body (12') is an elongated semiconductor heterostructure (13') configured for conduction of positive charge carriers, wherein the source (10') and the drain (14') are arranged on opposite distal regions (15',17') of the body (12');
wherein the bodies (12,12') are arranged separated, in parallel and superimposed relative to each other,
wherein the NMOS transistor (1) and the PMOS transistor (1') of the electrical device (100) are connected to form a circuit (200) for a complementary metal-oxide-semiconductor, CMOS (300).

2. The electrical device according to claim 1, wherein the elongated semiconductor heterostructure (13) of the NMOS transistor (1) comprises a heterojunction (11) configured for the conduction of negative charge carriers, the heterojunction (11) being formed by a top layer (18) and a bottom layer (20), both extending from a first end (22) to a second end (24) of the body (12); and
wherein the elongated semiconductor heterostructure (13) of the PMOS transistor (1) comprises a heterojunction (11') configured for the conduction of positive charges, the heterojunction (11') being formed by a top layer (18') and a bottom layer (20'), both extending from a first end (22') to a second end (24') of the body (12').

3. The electrical device according to claim 2, wherein the top and bottom layers (18,18',20,20') are made of AlGaN with an aluminum content of 0% or higher and wherein the content of aluminum in the top layers (18,18') are different to the content of aluminum in the bottom layers (20,20') for each of the elongated semiconductor heterostructures (13,13').

4. The electrical device according to any one of claims 1-3, wherein each of the elongated semiconductor heterostructures (13,13') has an axial length in a range of 200 to 50 nm and a largest cross section being less than 10 nm, preferably less than 5 nm.

5. The electrical device according to any one of claims 1-4, wherein each of the elongated semiconductor heterostructures (13,13') has a thickness in the range of 1-10 nm, preferably in the range 3-5 nm.

6. The electrical device according to any one of claims 1-5, wherein an insulating material (26) is arranged in between the bodies (12,12') of the NMOS transistor (1) and the PMOS transistor (1').

7. The electrical device according to claim 5, wherein the insulating material (26) is part of a cladding, the cladding enclosing the bodies (12,12').

8. The electrical device according to any one of claims 1-7 further comprising a gate (28) for controlling the charge carriers in the NMOS transistor (1) and the PMOS transistor (1'), wherein the gate (28) comprises a gate cladding structure (30) enclosing a central portion (32) of the bodies (12,12').

9. The electrical device according to claim 8, wherein the gate (28) comprises a gate layer stack structure (34) comprising a first layer comprising Ti and/or Ta, a second layer arranged on the first layer, the second layer comprising Al, a third layer arranged on the second layer, the third layer comprising one or more of Ni, Ti, Pt, Pd, Mo, Re, Ir, and a fourth layer arranged on the third layer, the fourth layer comprising Au.

10. The electrical device according to any one of claims 1-9, wherein the electrical device 100 is arranged on a substrate (36) and wherein the elongated semiconductor heterostructures (13,13') of the NMOS transistor (1) and the PMOS transistor (1'), are arranged such that the elongation extends is a direction (a) being parallel to the surface of the substrate (36).

11. A method of providing an electrical device configured to form a circuit (200) for a complementary metal-oxide-semiconductor, CMOS, (300), the method (400) comprising:

forming (402) a first stack of layers (40) on a substrate (36), the first stack of layers (40) comprising a first semiconductor heterostructure (42) comprising a top layer (18) and a bottom layer (20), and sacrificial layers (44a,44b) arranged above and below the first stack of layers (40);
forming (404) a second stack of layers (46) on and above the first stack of layers (40), the second stack of layers (46) comprising a second semiconductor heterostructure (48) comprising a top layer (18') and a bottom layer (20'), and sacrificial layers (44a',44b') arranged above and below the second stack of layers (46);

etching (406) the first and the second stack of layers (40,46) substantially in the vertical direction relative to the substrate (36) such that the semiconductor heterostructures (42,48) form elongated semiconductor heterostructures (13,13');

etching (408) the sacrificial layers (44a,44b,44a',44b');

forming (410) an insulating material (26) in the form of a cladding, the cladding enclosing the elongated semiconductor heterostructures (13,13').

12. The method according to claim 11 further comprising:
forming (412) a gate (28) substantially enclosing the insulating material (26) and the first and the second stack of layers (40,46).

13. The method according to any one of claims 11-12, wherein the forming (402) of the first stack of layers (40) comprises forming the first and second semiconductor heterostructures(13,13') such that the respective top layers (18,18') and bottom layers (20,20'), are made of AlGaN with an aluminum content of 0% or higher and wherein the content of aluminum in the top layers (18,18') s are different to the bottom layers (20,20').

14. The method according to any one of claims 11-13, wherein the first semiconductor heterostructure (13) comprises a first undoped GaN layer and a first AlGaN layer arranged on the first undoped GaN layer and the second semiconductor heterostructure (13') comprises second AlGaN layer and a second undoped GaN layer arranged on the second AlGaN layer.

15. A complementary metal-oxide-semiconductor, CMOS, (300) comprising the electrical device according to any one of claims 1-10.

100

18'
20'
28
1
10

34
1'
13'
11'
14'
18
20
33
33
36

13
11

22, 22'

*Fig. 1a*

100

18'
10'
20'
1

34
1'
13'
11'
28
14
18
20
33
33
36

13
11

24, 24'

*Fig. 1b*

37

100

15'

14'  27  26  28  34  30  32

1'

22, 22'

18'
20'

10

18
20

1

15

12

13'  12'  17'

13

14

11'

24, 24'

11

17

Fig. 1c

300

1'

200

V_in

308

1

V_DD

PMOS

NMOS

304

V_out

C_L

302

306

Fig.1d

400

S402

S404

S406

S408

S410

S412

S414

S416

S418

*Figure 2*

Fig. 3a

Fig. 3b

Fig. 4a

Fig. 4b

26

13'

S410

13

*Fig. 5a*

36

A

S410

26

13'

13

A

44b'
20'
48
18'
44a'

44b
20
42
18
44a

36

*Fig. 5b*

*Fig. 6a*

*Fig. 6b*

*Fig. 6c*

*Fig. 6d*

Fig. 7

Fig. 8

## EUROPEAN SEARCH REPORT

**Application Number**

EP 24 18 3491

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/108707 A1 (GARDNER MARK I [US] ET AL) 6 April 2023 (2023-04-06) | 1,2,4-8, 10-12,15 | INV.<br>H01L21/8258 |
| Y | * paragraphs [0029], [0033], [0045], | 13,14 | H01L27/06 |
| A | [0089] - [0105]; figures 33-47 * | 3,9 | H01L27/092<br>H01L29/778 |
| | ----- | | H01L29/20 |
| X | US 2023/106052 A1 (CHENG KAI [CN]) 6 April 2023 (2023-04-06) | 1-10,15 | |
| Y | * paragraphs [0004] - [0006], [0078], | 13,14 | ADD. |
| A | [0084], [0090], [0139] - [0171]; figures 13-20 * | 11,12 | H01L21/8238<br>H01L29/775 |
| | ----- | | |
| X | US 2024/006502 A1 (FROUGIER JULIEN [US] ET AL) 4 January 2024 (2024-01-04) | 1-8, 10-15 | |
| A | * paragraphs [0053], [0059], [0065] - [0070], [0090] - [0095]; figures 2, 4-11 * | 9 | |
| | ----- | | |

**TECHNICAL FIELDS SEARCHED (IPC)**

H01L

The present search report has been drawn up for all claims

| Place of search | Date of completion of the search | Examiner |
|---|---|---|
| Munich | 29 October 2024 | Seck, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 3491

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2024

| Patent document cited in search report | Publication date | Patent family member(s) | | Publication date |
|---|---|---|---|---|
| US 2023108707 A1 | 06-04-2023 | NONE | | |
| US 2023106052 A1 | 06-04-2023 | CN | 116325092 A | 23-06-2023 |
| | | US | 2023106052 A1 | 06-04-2023 |
| | | WO | 2022104801 A1 | 27-05-2022 |
| US 2024006502 A1 | 04-01-2024 | NONE | | |

EPO FORM P0459

For more details about this annex : see Official Journal of the European Patent Office, No. 12/82